Europäisches Patentamt

European Patent Office

Office européen des brevets

(11) Publication number: **0 355 165 B1**

# EUROPEAN PATENT SPECIFICATION

(45) Date of publication of patent specification: **22.03.95**

(51) Int. Cl.[6]: **C04B 35/00**, C04B 41/87, C23C 14/08, H01B 12/00, H01L 39/12

(21) Application number: **88909819.0**

(22) Date of filing: **15.11.88**

(86) International application number: **PCT/JP88/01148**

(87) International publication number: **WO 89/04816 (01.06.89 89/12)**

(54) **PROCESS OF MANUFACTURING TARGET USED FOR FORMATION OF SUPERCONDUCTIVE FILM.**

(30) Priority: **26.11.87 JP 298320/87**

(43) Date of publication of application:
**28.02.90 Bulletin 90/09**

(45) Publication of the grant of the patent:
**22.03.95 Bulletin 95/12**

(84) Designated Contracting States:
**DE FR GB**

(56) References cited:

**PATENT ABSTRACTS OF JAPAN, (E-172), 27th April 1983; & JP-A-58 021 880**

**Physical Review Letters, Vol. 58, No. 9, (1987), C.W. Chu, et al. (Superconductivity at 93K in a New Mixed-Phase Y-Ba-Cu-O Compound System at Ambient Pressure) P.908-910**

(73) Proprietor: **MITSUBISHI MATERIALS CORPORATION**
**6-1, Otemachi 1-chome**
**Chiyoda-ku**
**Tokyo (JP)**

(72) Inventor: **TAKESHITA, Takuo Mitsubishi K.K.K. Chuo Kenkyujo**
**297, Kitabukurocho 1-chome**
**Omiya-shi**
**Saitama 330 (JP)**
Inventor: **SUGHIHARA, Tadashi Mitsubishi K.K.K. Chuo Kenkyjo**
**297, Kitabukurocho 1-chome**
**Omiya-shi**
**Saitama 330 (JP)**

(74) Representative: **Glawe, Delfs, Moll & Partner**
**Patentanwälte**
**Postfach 26 01 62**
**D-80058 München (DE)**

EP 0 355 165 B1

Japanese Journal of Applied Physics, Vol. 26, No. 5, (1987), M. Kawasaki, et al. (High Tc Yb-Ba-Cu-O Thin Films Deposited on Sintered YSZ Substrates by Sputtering), P.L738-L740

Japanese Journal of Applied Physics, Vol. 26, No. 7, (1987), Y. Enomoto, et al. (Largely Anisotropic Superconducting Critical Current in Epitaxially Grown Ba2 Y Cu3 O7-y Thin Film)P.L1248-L1251

## Description

TECHNICAL FIELD

This invention relates to a target used in a sputtering system and, more particularly, to a process of manufacturing a target used for forming a superconductive film by a sputtering technique.

BACKGROUND ART

A prior-art process of manufacturing a target used in a sputtering technique for forming a superconductive film on a surface of a substrate starts with preparation of raw powders, that is, an oxide powder containing a rare earth element such as, for example, yttrium, a carbonate of an alkaline earth metal and a copper oxide each less in average diameter than 10 $\mu$m, and these raw powders are then mixed together in predetermined proportions. The mixture of the raw powders is placed in an oxidation ambient at a certain temperature ranging between 850 degrees and 950 degrees in centigrade for a calcining, and the calcined product is pulverized. The calcining and the pulverization are repeated more than twice, if necessary, for producing a powder of a superconductive ceramic material including an oxygen compound containing the rare earth element such as, for example, yttrium, the alkaline earth metal and copper.

Subsequently, the powder of the superconductive ceramic powder is shaped by using a hot press technique for producing a target in the following conditions;

in a vacuum ambient of 1,3 Pa [$10^{-2}$ Torr]

at a heating temperature between 800 degrees and 900 degrees in centigrade

for retentive time period for heating ranging between an hour and 4 hours.

However, the superconductive ceramic material as the raw powder has various crystal structures. For example, a composition represented by the molecular formula of $YB_2Cu_3O_x$ ( where x is not less than 6.5 ) has a rhombic crystal structure, however, if being represented by the molecular formula of $YB_2Cu_3O_x$ ( where x is less than 6.5 ), it has a tetragonal crystal structure. If the two kinds of structure coexist with each other, a residual strain takes place in the target through a cooling stage carried out after the sintering. This is because of the fact that compositions different in crystal structure have respective thermal expansion coefficients different from each other, so that problems are encountered in that cracks and a deformation tend to take place in the target due to the residual strain and that cracks are liable to be produced during a sputtering process.

DISCLOSURE OF INVENTION

Researches have been made by the inventors for fabrication of a target which is free from the residual strain and used for a formation of a superconductive film. As a result, it is discovered that if the hot pressing conditions are changed as follows, the superconductive ceramic powder is homogeneous in composition and, accordingly, conducive to producing a uniformity in crystal structure.

First, the vacuum ambient is changed into an oxygen contained argon ambient with a pressure range between 133 Pa [1 Torr] and 13,3 kPa [100 Torr] containing oxygen ranging between 0.1 % and 10 % by volume at a certain temperature between 350 degrees and 700 degrees in centigrade during the temperature elevation stage toward the heating temperature, and, then, the superconductive ceramic powder is placed in the oxygen contained ambient between about one hour and 10 hours. If the hot pressing is carried out in the homogeneous state of the composition, the target is formed of a homogeneous sintered product, and, as a result, the residual strain due to an irregularity of the composition hardly takes place in the cooling stage. Therefore, the cracks and the deformation are less liable to be produced in the target.

A process of fabricating a target used for a formation of a superconductive film according to the present invention comprises the steps of preparing a powder of a superconductive ceramic material mainly constituted by an oxygen compound containing a rare earth element such as, for example, yttrium, an alkaline earth metal and copper, and heating the powder of the superconductive ceramic material in a vacuum not greater than 1,3 Pa [$10^{-2}$ Torr] to a first predetermined temperature ranging between about 800 degrees and about 900 degrees in centigrade for keeping between about one hour and about 4 hours under a pressurized state between about 10 MPa [100 kgf/cm$^2$] and about 20 MPa [200 kgf/cm$^2$], and is characterized by changing the vacuum to an oxygen containing noble gas ambient between about 133 Pa [1 Torr] and about 13,3 kPa [100 Torr] containing oxygen ranging between about 0.1 % and about 10 % by volume at a second predetermined temperature ranging between 350 degrees and 700 degrees in

3

centigrade during the temperature elevation stage to the first predetermined temperature and by keeping the powder of the superconductive ceramic material in the noble gas ambient for about 1 hour and about 10 hours.

Description is made for the reasons why the second predetermined temperature, the composition, the pressure and the retentive time period are selected to be above in the process according to the present invention.

In a temperature less than 350 degrees in centigrade, the homogenization of the composition is too slow to be applied to a practical application. On the other hand, if the temperature is greater than 700 degrees in centigrade, the furnace is clearly damaged due to oxygen attack, thereby being decreased in running time period. For these reasons, the second predetermined temperature is decided between about 350 degrees and about 700 degrees in centigrade.

If the oxygen content is less than 0.1 % by volume or the pressure is less than 133 Pa [1 Torr], the homogenization process is incomplete. This results in that the residual strain is left in the target. On the other hand, the oxygen content is greater than 10 % by volume or the pressure excesses 13,3 kPa [100 Torr], the oxygen damages are promoted in the furnace. For these reasons, the oxygen content in the noble gas ambient and the pressure thereof are selected to range between about 0.1 % and about 10 % by volume and between about 133 Pa [1 Torr] and about 13,3 kPa [100 Torr], respectively.

If the retentive time period is less than an hour, the homogenization process is incomplete, and, on the other hand, even if the retentive time period is established over 10 hours, no difference in homogenization is achieved between the superconductive ceramics, therefore being wasteful. The retentive time period is decided between about an hour and about 10 hours for the reasons described hereinbefore.

## BEST MODE FOR CARRYING OUT THE INVENTION

The process according to the present invention is described in detail by examples.

Preparing raw powders, that is, superconductive ceramic powders each less than 5 $\mu$m in average diameter and having a composition indicated in Table 1 ( in the compositions indicated in Table 1 R is representative of a rare earth element such as, for example, yttrium, A is indicative of an alkaline earth metal and O stands for oxygen ), each of the raw powders is subjected to a hot pressing under the conditions indicated in Table 1. During the temperature elevation stage, the vacuum ambient is changed to an oxygen containing noble gas ambient, for example containing argon, also indicated in Table 1, and target groups 1 to 15 are produced in a configuration of 125 millimeters in diameter and 6 millimeters in thickness. Moreover, other target groups 1 to 15 are produced into a configuration of 125 millimeters in diameter and 6 millimeters in thickness under the conditions similar to those of the prior art except for a vacuum ambient of 0,13 Pa [$10^{-3}$ Torr] in the temperature elevation stage toward the heating temperature for the sake of comparison use. The prior-art fabrication process are carried out for the target groups 1 to 15 under the conditions indicated in Table 2.

Regarding each of the target groups 1 to 15 for forming the superconductive films produced in accordance with the present invention, the number of the targets with cracks picked up from the 10 targets is counted, and the maximum deformation in the direction of the thickness is measured as indicated in Table 1. The similar measurements are carried out for each of the target groups 1 to 15 produced by using the prior-art manufacturing process, and the results are indicated in Table 2.

Comparing the results in Table 1 with the results in Table 2, it is understood that the target groups 1 to 15 produced by using the manufacturing process of the present invention are drastically reduced in the production of the cracks and in the amount of the deformation in comparison with the target groups 1 to 15 produced by using the prior-art process.

As described above, the powder of the superconductive ceramic material is hot pressed under the homogeneous composition in the fabrication process of the present invention, and, accordingly, a negligible amount of the internal residual strain is merely produced in the target, so that the production of the cracks and the deformation is restricted in the manufactured target. This results in an advantage in enhancement of the production yield.

## Table 1(1)

| Target group | | Composition of Superconductive ceramics (% by weight) | | | |
|---|---|---|---|---|---|
| | | R | A | Cu | O |
| P R E S E N T | 1 2 | Y: 13.4 | Ba: 41.4 | 28.8 | residual |
| | 3 4 5 | Y: 10.1 | Ba: 36.0 | 32.6 | residual |
| T | 6 | Er:22.6 | Ba: 37.0 | 25.7 | residual |
| I N | 7 | Dy:22.1 | Ba: 37.3 | 25.9 | residual |
| V E | 8 | Yb:23.2 | Ba: 36.8 | 25.5 | residual |
| N T | 9 | Gd:21.5 | Ba: 37.6 | 26.1 | residual |
| I O | 10 | Tm:22.7 | Ba: 37.0 | 25.7 | residual |
| N | 11 | Nd:20.1 | Ba: 38.2 | 26.5 | residual |
| | 12 | Lu:21.2 | Ba: 38.8 | 25.6 | residual |
| | 13 | Sm:20.8 | Ba: 37.9 | 26.3 | residual |
| | 14 | Y: 14.5 | Ba: 22.4 Sr: 14.3 | 31.1 | residual |
| | 15 | Eu:21.2 | Ba: 36.4 Ca: 0.6 | 26.6 | residual |

Table 1(2)

|  | Target group | Oxygen contained ambient in temperature elevation stage | | | |
|---|---|---|---|---|---|
|  |  | Temperature (deg. in Centigrade) | Oxygen content (volume %) | Pressure [Torr] (Pa) | Retentive time (hours) |
| PRESENT | 1 | 350 | 10 | [50] 6650 | 5 |
|  | 2 | 420 | 7 | [1] 133 | 10 |
|  | 3 | 700 | 0.1 | [100] 13300 | 8 |
|  | 4 | 540 | 2 | [50] 6650 | 5 |
|  | 5 | 600 | 5 | [65] 8645 | 1 |
| INVENTION | 6 7 8 9 10 11 12 13 14 15 | 540 | 5 | [50] 6650 | 4 |

Table 1(3)

| | | Ambient pressure [Torr] (Pa) | Heating temp. (deg. in centigrade) | Pressure $\left[\frac{kgf}{cm^2}\right]$ (MPa) | Retentive time (hours) | No. of targets cracked | Maximum deformation (mm) |
|---|---|---|---|---|---|---|---|
| **P R E S E N T   I N V E N T I O N** | 1 | 0.13 [$10^{-3}$] | 800 | [200] 20 | 1.5 | 0/10 | 0.1 |
| | 2 | | 850 | [150] 15 | 2 | 0/10 | 0.1 |
| | 3 | | 900 | [140] 14 | 1 | 1/10 | 0.3 |
| | 4 | | 850 | [170] 17 | 3 | 0/10 | 0.2 |
| | 5 | | 800 | [100] 10 | 4 | 0/10 | 0.1 |
| | 6 | | 850 | [150] 15 | 2 | 0/10 | 0.1 |
| | 7 | | | | | 0/10 | 0.1 |
| | 8 | | | | | 0/10 | 0.1 |
| | 9 | | | | | 0/10 | 0.1 |
| | 10 | | | | | 0/10 | 0.1 |
| | 11 | | | | | 1/10 | 0.2 |
| | 12 | | | | | 1/10 | 0.1 |
| | 13 | | | | | 0/10 | 0.1 |
| | 14 | | | | | 0/10 | 0.1 |
| | 15 | | | | | 0/10 | 0.1 |

7

Table 2(1)

| Composition of superconductive ceramics (% by weight) | | Oxygen containing ambient in temperature elevation stage | | | |
|---|---|---|---|---|---|
| Target Group | R A Cu O | Temp. (deg.in centi-grade) | Content of oxygen (vol.%) | Pressure [Torr] (Pa) | Retentive time(hours) |
| 1 | Same as group 1 of the present invention | not carried out | | | |
| 2 | Same as group 2 of the present invention | not carried out | | | |
| 3 | Same as group 3 of the present invention | not carried out | | | |
| 4 | Same as group 4 of the present invention | not carried out | | | |
| 5 | Same as group 5 of the present invention | not carried out | | | |
| 6 | Same as group 6 of the present invention | not carried out | | | |
| 7 | Same as group 7 of the present invention | not carried out | | | |
| 8 | Same as group 8 of the present invention | not carried out | | | |
| 9 | Same as group 9 of the present invention | not carried out | | | |

PRIOR ART

Table 2(1)

| | | | |
|---|---|---|---|
| P R I O R  A R T | 10 | Same as group 10 of the present invention | not carried out |
| | 11 | Same as group 11 of the present invention | not carried out |
| | 12 | Same as group 12 of the present invention | not carried out |
| | 13 | Same as group 13 of the present invention | not carried out |
| | 14 | Same as group 14 of the present invention | not carried out |
| | 15 | Same as group 15 of the present invention | not carried out |

Table 2 (2)

| Conditions of vacuum hot pressing | | | | | | |
|---|---|---|---|---|---|---|
| | Ambient pressure [(Torr)] (Pa) | Heating temp. (deg. in centigrade) | Pressure $\left[\dfrac{kgf/}{cm^2}\right]$ (MPa) | Retentive time (hours) | No. of targets cracked | Maximum defor- mation (mm) |
| 1 | Same as group 1 of the present invention | | | | 1/10 | 0.5 |
| 2 | Same as group 2 of the present invention | | | | 1/10 | 0.6 |
| 3 | Same as group 3 of the present invention | | | | 3/10 | 1.0 |
| 4 | Same as group 4 of the present invention | | | | 2/10 | 0.6 |
| 5 | Same as group 5 of the present invention | | | | 1/10 | 0.5 |
| 6 | Same as group 6 of the present invention | | | | 1/10 | 0.5 |
| 7 | Same as group 7 of the present invention | | | | 2/10 | 0.7 |
| 8 | Same as group 8 of the present invention | | | | 2/10 | 0.8 |
| 9 | Same as group 9 of the present invention | | | | 1/10 | 0.5 |
| 10 | Same as group 10 of the present invention | | | | 1/10 | 0.6 |
| 11 | Same as group 11 of the present invention | | | | 3/10 | 0.8 |
| 12 | Same as group 12 of the present invention | | | | 3/10 | 0.8 |
| 13 | Same as group 13 of the present invention | | | | 1/10 | 0.5 |
| 14 | Same as group 14 of the present invention | | | | 2/10 | 0.7 |
| 15 | Same as group 15 of the present invention | | | | 1/10 | 0.5 |

(PRIOR ART)

## INDUSTRIAL APPLICABILITY

The target for forming a superconductive film manufactured by using the process according to the present invention is useful for forming a superconductive wiring strip on a substrate by using a sputtering technique.

## Claims

1. A process of manufacturing a target for use in formation of a superconductive film, comprising the steps of:

preparing a powder of superconductive ceramic material mainly constituted of an oxygen-compound containing a rare earth element, such as yttrium, an alkaline earth metal and copper;

hot-pressing said powder by applying to it a pressure between about 10 and 20 MPa and heating the powder to a final temperature between about 800 and 900 °C;

applying a vacuum with a pressure not exceeding 1,3 Pa while said powder being heated has a temperature below an intermediate temperature ranging between 350 and 700 °C;

at said intermediate temperature changing the vacuum to an oxygen containing noble gas ambient having a pressure between about 0,13 and 13 kPa, the oxygen content of said ambient ranging between about 0,1% and 10% by volume;

keeping the powder in the pressurized state in said noble gas ambient for the time between 1 hour and 10 hours.

2. A process of fabricating a target used for a formation of a superconductive film as set forth in claim 1, in which said nobel gas ambient contains an argon gas.

**Patentansprüche**

1. Verfahren zur Herstellung eines Targets zur Verwendung bei der Bildung eines supraleitfähigen Films mit den Schritten:

Bereiten eines Pulvers aus supraleitendem keramischen Material, hauptsächlich bestehend aus einer Sauerstoffverbindung, die ein Seltene-Erden-Element, wie Yttrium, ein Alkali-Erdmetall und Kupfer enthält;

Heißpressen des Pulvers durch Anlegen eines Drucks zwischen etwa 10 und 20 MPa und Erhitzen des Pulvers auf eine Endtemperatur zwischen etwa 800 und 900 °C;

Anlegen eines Vakuums mit einem Druck nicht über 1,3 Pa, während das Pulver bei seiner Erhitzung eine Temperatur unteralb einer Zwischentemperatur im Bereich zwischen 350 und 700 °C hat;

Ändern des Vakuums bei der Zwischentemperatur in eine Sauerstoff enthaltende Edelgasatmosphäre mit einem Druck zwischen etwa 0,13 und 13 kPa, wobei der Sauerstoffgehalte der Atmosphäre im Bereich zwischen etwa 0,1 und 10 Vol% liegt;

Halten des Pulvers unter dem Preßdruck in der Edelgasatmosphäre für eine Zeitdauer zwischen einer Stunde und 10 Stunden.

2. Verfahren zur Herstellung des Targets zur Verwendung bei der Bildung eines supraleitfähigen Films nach Anspruch 1, wobei die Edelgasatmosphäre Argongas enthält.

**Revendications**

1. Procédé de préparation d'une cible pour utilisation dans la formation d'un film supraconducteur, comprenant les étapes de :
   - préparer une poudre de matériau céramique supraconducteur constitué principalement d'un composé oxygène contenant un élément terre rare, tel que l'yttrium, un métal alcalino-terreux et du cuivre;
   - presser à chaud ladite poudre en lui appliquant une pression entre environ 10 et 20 MPa et chauffer la poudre à une température finale ente environ 800 et 900 °C;
   - appliquer un vide avec une pression n'excédant pas 1,3 Pa tandis que ladite poudre est chauffée à une température inférieure à une température intermédiaire variant entre 350 et 700 °C;
   - à cette température intermédiaire changer le vide pour une atmosphère de gaz noble contenant de l'oxygène possédant une pression entre environ 0,13 et 13 kPa, la teneur en oxygène de ladite atmosphère variant entre environ 0,1 % et 10 % en volume;
   - garder la poudre en état pressurisé dans ladite atmosphère de gaz noble pendant un temps entre 1 et 10 heures.

2. Procédé de préparation d'une cible utilisée pour la formation d'un film supraconducteur selon la revendication 1, dans lequel ladite atmosphère de gaz noble contient un gaz argon.